# DEMANDE DE BREVET EUROPEEN

(11) **EP 3 470 384 A1**
(43) Date de publication de la demande: **17.04.2019**
(21) Numéro de dépôt: 17196219.4
(22) Date de dépôt: 12.10.2017
(51) Int. Cl.: C04B 35/10, C04B 35/48, C04B 35/56, C04B 35/565, C04B 35/584, C04B 35/628

(54) **PROCÉDÉ DE TRAITEMENT DE SURFACE DE PARTICULES D'UNE POUDRE CÉRAMIQUE ET PARTICULES DE POUDRE CÉRAMIQUE OBTENUES GRÂCE À CE PROCÉDÉ**

(71) Demandeur: The Swatch Group Research and Development Ltd, 2074 Marin (CH)
(72) Inventeur: Miko, Csilla, 1417 Essertines-sur-Yverdon (CH); Bazin, Jean-Luc, 2512 Tüscherz-Alfermée (CH)
(74) Mandataire: ICB SA

(57) **Abrégé**

L'invention concerne un procédé de traitement de surface d'un matériau céramique à l'état de poudre, ce procédé comprenant l'étape qui consiste à se munir d'une poudre formée d'une pluralité de particules du matériau céramique à traiter, et à soumettre ces particules de poudre céramique à un processus d'implantation ionique en dirigeant vers une surface extérieure de ces particules un faisceau d'ions (14) monochargés ou multichargés produit par une source d'ions monochargés ou multichargés par exemple du type à résonance cyclotron électronique ECR, ces particules présentant une forme générale polyédrique.

L'invention concerne également un matériau à l'état de poudre formé d'une pluralité de particules ayant une couche extérieure (26) céramique et un coeur (24) céramique, ces particules ayant une forme générale polyédrique.

## Description

### Domaine technique de l'invention

La présente invention concerne un procédé de traitement de surface de particules d'un matériau céramique à l'état de poudre ainsi que des particules de poudre céramique obtenues par la mise en oeuvre d'un tel procédé. Les particules de poudre céramique obtenues grâce au procédé selon l'invention sont destinées à la fabrication de produits façonnés, c'est-à-dire des pièces livrées sous leur forme définitive et réalisées grâce à des procédés de frittage tels que le frittage à la pression atmosphérique, ou bien le frittage sous pression, encore connu sous sa dénomination anglo-saxonne Hot Isostatic Pressing ou HIP.

### Arrière-plan technologique de l'invention

Les propriétés mécaniques et physiques des matériaux sont intimement liées à la structure électronique des atomes qui les composent et à la manière dont ils sont liés les uns aux autres. Les matériaux peuvent ainsi être classifiés en trois grandes catégories suivant le type de liaison entre les atomes qui les composent : les métaux (liaisons métalliques), les céramiques (liaison covalente ou ionique) et les polymères (liaison hydrogène). Comme les liaisons covalentes et ioniques sont énergiquement plus fortes que les liaisons métalliques, les céramiques sont plus dures, possèdent un plus haut point de fusion et une plus grande stabilité chimique que les métaux. Par ailleurs, l'absence d'électrons libres fait que les céramiques ont une conductivité électrique et thermique très faible. Pour ces mêmes raisons, il existe un certain antagonisme entre la dureté d'un matériau (qui dépend de la force de la liaison entre les atomes et leur capacité à ne pas se déplacer sous la contrainte), et sa résistance aux chocs (qui dépend de la capacité du matériau à dissiper de l'énergie au travers du mouvement des atomes).

On peut définir les matériaux céramiques comme étant des matériaux inorganiques, non métalliques, nécessitant de hautes températures lors de leur fabrication. La cuisson ou frittage des matériaux céramiques se fait cependant à des températures bien inférieures à leur température de fusion. Si l'on compare les matériaux céramiques aux verres, les deux types de matériaux peuvent être obtenus à partir des mêmes matières premières. La différence réside cependant dans le fait que, dans le cas du verre, la matière première est portée à son point de fusion et, une fois l'état liquide obtenu, on met la matière première en forme par exemple par soufflage ou moulage. A l'inverse, pour élaborer une pièce en matériau céramique, on commence par la phase de mise en forme, à température ambiante, de la matière première à l'état de poudre. Très souvent, cette étape de mise en forme est réalisée en mélangeant la poudre à un liquide ou en utilisant toutes sortes d'additifs afin de favoriser l'homogénéité de l'ébauche de la pièce finale recherchée, mais aussi d'influer sur les caractéristiques de cette pièce. Ensuite, la cuisson de l'ébauche se fait à une température bien inférieure à la température de fusion du matériau céramique. Lors de cette étape de cuisson, les particules de poudre céramique s'agrègent les unes aux autres, ce qui provoque l'élimination de la plupart des pores ou des cavités, et, en conséquence, l'ébauche se contracte et durcit, tout en gardant sa forme de départ. Cette étape de cuisson s'appelle le frittage.

Les matériaux céramiques ont en général une structure cristalline, parfois associée à une phase amorphe. On peut classer les matériaux céramiques selon leur application :
1. les céramiques traditionnelles qui sont destinées à un usage alimentaire ou à l'ornementation (poterie, vaisselle, faïence, porcelaine), ou bien encore au bâtiment (carrelage, briques, tuiles) ;
2. les céramiques dites industrielles ou techniques parmi lesquelles on peut citer :
   - les céramiques électroniques ou fonctionnelles utilisées dans des applications mettant en jeu de faibles courants (céramiques diélectriques (isolantes), céramiques piézoélectriques, céramiques conductrices, céramiques magnétiques, céramiques supraconductrices) ;
   - les céramiques électrotechniques destinées à des applications mettant en jeu de fortes puissances ;
   - les céramiques réfractaires pour les applications thermiques ;
   - les céramiques pour des applications mécaniques telles que les céramiques structurales et les céramiques destinées aux opérations d'usinage (les abrasifs pour les opérations de polissage et les plaquettes de carbure pour les outils de coupe) ;
   - les céramiques utilisées pour réaliser des supports de catalyseurs dans l'industrie chimique et des pots catalytiques notamment dans l'industrie automobile ;
   - les céramiques pour les applications optiques (transparence, émission de lumière) :
   - les céramiques destinées à être utilisées pour le confinement de combustible nucléaire.

La présente invention s'intéresse plus particulièrement aux céramiques techniques.

On peut également classer les produits céramiques selon leur composition chimique. Dans la catégorie des matériaux céramiques monolithiques, on distingue :
1. les oxydes, à savoir
   - les produits siliceux à base de silice SiO₂ ;
   - les produits alumineux comprenant de 30 à 100% d'alumine Al₂O₃ ;
   - les produits basiques à base de magnésie MgO ;
   - les produits spéciaux tels que la zircone Zr02 ou bien les polycristaux tétragonaux de zircone stabilisés par yttrium (Y-TZP ou Yttrium Stabilized Tetragonal Zirconia Polycristals en terminologie anglo-saxonne).
2. les non-oxydes, à savoir les carbures, les nitrures et les borures.

Il existe également des matériaux céramiques composites tels que les matériaux à matrice céramique renforcée par une céramique, par exemple par de la zircone Zr02, ou bien les matériaux à matrice céramique renforcée par un métal.

La présente invention s'intéresse tout aussi bien aux oxydes qu'aux non-oxydes.

Les procédés d'implantation ionique consistent à bombarder la surface d'un objet à traiter par exemple au moyen d'une source d'ions mono- ou multichargés du type à résonance cyclotron électronique. Une telle installation est encore connue sous sa dénomination anglo-saxonne Electron Cyclotron Résonance ou ECR.

Une source d'ions ECR fait usage de la résonance cyclotronique des électrons pour créer un plasma. Un volume de gaz à basse pression est ionisé au moyen de micro-ondes injectées à une fréquence correspondant à la résonance cyclotron électronique définie par un champ magnétique appliqué à une région située à l'intérieur du volume de gaz à ioniser. Les micro-ondes chauffent les électrons libres présents dans le volume de gaz à ioniser. Ces électrons libres, sous l'effet de l'agitation thermique, vont entrer en collision avec les atomes ou les molécules de gaz et provoquer leur ionisation. Les ions produits correspondent au type de gaz utilisé. Ce gaz peut être pur ou composé. Il peut également s'agir d'une vapeur obtenue à partir d'un matériau solide ou liquide. La source d'ions ECR est en mesure de produire des ions simplement chargés, c'est-à-dire des ions dont le degré d'ionisation est égal à 1, ou bien des ions multichargés, c'est-à-dire des ions dont le degré d'ionisation est supérieur à 1.

Une source d'ions multichargés du type à résonance cyclotron électronique ECR est schématiquement illustrée sur la figure 1 annexée à la présente demande de brevet. Désignée dans son ensemble par la référence numérique générale 1, une source d'ions multichargés ECR comprend un étage d'injection 2 dans lequel on introduit un volume 4 d'un gaz à ioniser et une onde hyperfréquence 6, un étage de confinement magnétique 8 dans lequel est créé un plasma 10, et un étage d'extraction 12 qui permet d'extraire et d'accélérer les ions du plasma 10 au moyen d'une anode 12a et d'une cathode 12b entre lesquelles est appliquée une haute tension. Un faisceau d'ions multichargés 14 produit en sortie de la source d'ions multichargés ECR 1 vient frapper une surface 16 d'une pièce à traiter 18 et pénètre plus ou moins profondément dans le volume de la pièce à traiter 18.

L'implantation d'ions par bombardement de la surface d'un objet à traiter a de nombreux effets parmi lesquels la modification de la microstructure du matériau dans lequel l'objet à traiter est réalisé, l'amélioration de la résistance à la corrosion, l'amélioration des propriétés tribologiques et, plus généralement, l'amélioration des propriétés mécaniques. Plusieurs travaux ont ainsi mis en évidence l'augmentation de la dureté du cuivre et du bronze par implantation ionique d'azote. Il a également été démontré que l'implantation d'azote ou de néon dans le cuivre permet d'augmenter sa résistance à la fatigue. De même, des travaux ont montré qu'une implantation d'azote, même à faible dose (1.10¹⁵ et 2.10¹⁵ ions.cm⁻²), était suffisante pour modifier de manière significative le module de cisaillement du cuivre.

On comprend donc que l'implantation d'ions par bombardement de la surface d'un objet à traiter présente de grands intérêts tant d'un point de vue scientifique que technique et industriel.

Néanmoins, les études menées jusqu'à ce jour ne se sont intéressées qu'à des objets à traiter massifs. Or, de tels objets massifs sont nécessairement limités par les formes et la géométrie qu'il est possible de leur donner grâce aux techniques d'usinage classiques (perçage, fraisage, alésage etc.).

Il existait donc dans l'état de la technique un besoin pour des objets dont les propriétés mécaniques soient améliorées de manière significative tout en n'opposant quasiment aucune limite quant à la forme que de tels objets pouvaient prendre.

### Résumé de l'invention

La présente invention a pour but de répondre au besoin mentionné ci-dessus ainsi qu'à d'autres encore en proposant un procédé de traitement de surface d'un matériau céramique permettant de réaliser des objets dont les formes géométriques sont pratiquement libres de toute contrainte, tout en présentant des propriétés physiques et chimiques modifiées et améliorées.

A cet effet, la présente invention concerne un procédé de traitement de surface d'un matériau céramique, ce procédé comprenant l'étape qui consiste à se munir d'une poudre formée d'une pluralité de particules d'un matériau céramique, et à diriger vers une surface de ces particules un faisceau d'ions monochargés ou multichargés produit par une source d'ions monochargés ou multichargés, les particules présentant une forme générale sphérique.

Selon des formes préférentielles d'exécution de l'invention :
- la source d'ions mono- ou multichargés est du type à résonance cyclotron électronique ECR ;
- on agite les particules de la poudre céramique durant toute la durée du processus d'implantation ionique ;
- la granulométrie des particules de la poudre céramique utilisée est telle que sensiblement 50% de l'ensemble de ces particules a une dimension inférieure à 2 micromètres, la dimension des particules de la poudre céramique utilisée n'excédant pas 60 micromètres ;
- le matériau à ioniser est choisi parmi le carbone, l'azote et le bore ;
- les ions monochargés ou multichargés sont accélérés sous une tension comprise entre 15'000 et 35'000 volts ;
- la dose d'ions implantés est comprise entre 1.10¹⁴ et 5.10¹⁷ ions.cm⁻², de préférence entre 1.10¹⁶ et 1.10¹⁷ ions.cm⁻²
- la profondeur maximale d'implantation des ions est de 150 à 250 nm ;
- le matériau céramique traité selon le procédé d'implantation ionique conforme à la présente invention est un carbure, en particulier un carbure de titane TiC ou un carbure de silicium SiC ;
- le matériau céramique de type carbure est bombardé au moyen d'ions azote N pour former un carbonitrure, notamment du carbonitrure de titane TiCN ou bien du carbonitrure de silicium SiCN ;
- le matériau céramique traité selon le procédé d'implantation ionique selon l'invention est un nitrure, en particulier un nitrure de silicium Si₃N₄ ;
- le matériau céramique de type nitrure est bombardé au moyen d'une dose d'ions comprise entre 1*10¹⁶ cm⁻² et 1*10¹⁷ cm⁻².
- le matériau céramique traité selon le procédé d'implantation ionique conforme à la présente invention est un oxyde, notamment de la zircone Zr02 ou de l'alumine Al₂O₃ ;
- le matériau céramique de type oxyde est bombardé au moyen d'ions azote pour former un oxynitrure, notamment de l'oxynitrure de zircone ZrO(NO₃)₂, voire du nitrure de zirconium ZrN si l'on prolonge le bombardement ionique suffisamment longtemps, ou bien encore du nitrure d'alumine AlOₓNy ;
- le matériau céramique de type oxyde est bombardé au moyen d'ions carbone pour former un carbonitrure, notamment du carbure de zircone ZrO₂C, voire du carbure de zirconium ZrC ;
- le matériau céramique de type oxyde est bombardé au moyen d'ions bore pour former un oxyborure, notamment du borure de zircone Zr02 B, voire du borure de zircone ZrB2 si l'on prolonge le bombardement ionique suffisamment longtemps.

La présente invention concerne également une particule d'une poudre céramique avec une surface céramique et un coeur céramique, et plus particulièrement avec une surface qui correspond à un carbure, à un nitrure ou à un borure du matériau céramique dans lequel sont réalisées les particules de la poudre céramique.

Grâce à ces caractéristiques, la présente invention procure un procédé de traitement d'un matériau céramique à l'état de poudre dans lequel les particules formant cette poudre conservent leur structure céramique d'origine en profondeur, tandis que, depuis la surface et jusqu'à une certaine profondeur, les ions monochargés ou multichargés avec lesquels les particules de poudre céramique sont bombardées viennent modifier les propriétés de surface de ces particules de poudre céramique en améliorant notamment l'aptitude de ces particules de poudre céramique au compactage et au frittage, ce qui permet ultérieurement d'améliorer les propriétés d'usinage et les caractéristiques tribologiques des pièces réalisées au moyen de ces particules de poudre céramique.

On notera que les particules de poudre céramique, après traitement par implantation ionique, sont prêtes à être utilisées dans des procédés de frittage des poudres céramiques tels que le procédé de frittage à la pression atmosphérique ou bien le procédé de frittage sous pression encore connu sous sa dénomination anglo-saxonne Hot Isostatic Pressing ou HIP. Par ailleurs, du fait que la surface des particules de poudre céramique se transforme en borure, en carbure ou bien encore en nitrure du matériau céramique qui constitue ces particules, les propriétés physiques et mécaniques initiales de ces poudres telles que la rhéologie, la coulabilité ou bien encore la mouillabilité sont modifiées. Il en résulte que les propriétés des revêtements de surface et des pièces massives réalisés avec ces poudres telles que la dureté, la tribologie ou bien encore l'aspect esthétique sont améliorées.

De préférence, les particules formant la poudre céramique sont agitées durant toute la durée du traitement d'implantation ionique afin que ces particules soient exposées aux ions du faisceau d'implantation de manière homogène sur toute leur surface.

### Brève description des figures

D'autres caractéristiques et avantages de la présente invention ressortiront plus clairement de la description détaillée qui suit d'un exemple de mise en oeuvre du procédé selon l'invention, cet exemple étant donné à titre purement illustratif et non limitatif seulement en liaison avec le dessin annexé sur lequel :

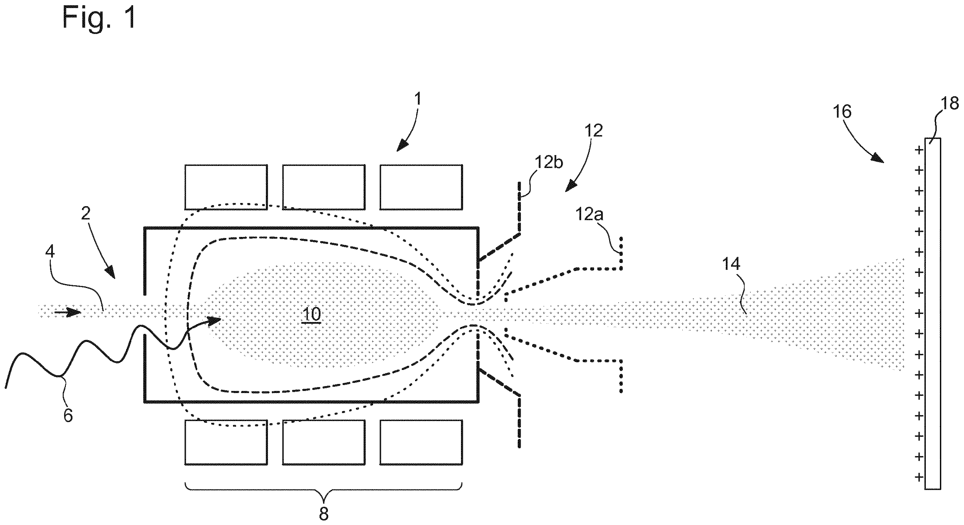

- la figure 1, déjà citée, est une représentation schématique d'une source d'ions multichargés du type à résonance cyclotron électronique ECR ;
- la figure 2 est une vue en coupe d'une particule d'alumine Al₂O₃ dont le rayon est d'environ 1 micromètre et qui a été bombardée au moyen d'un faisceau d'ions azote N⁺ , et

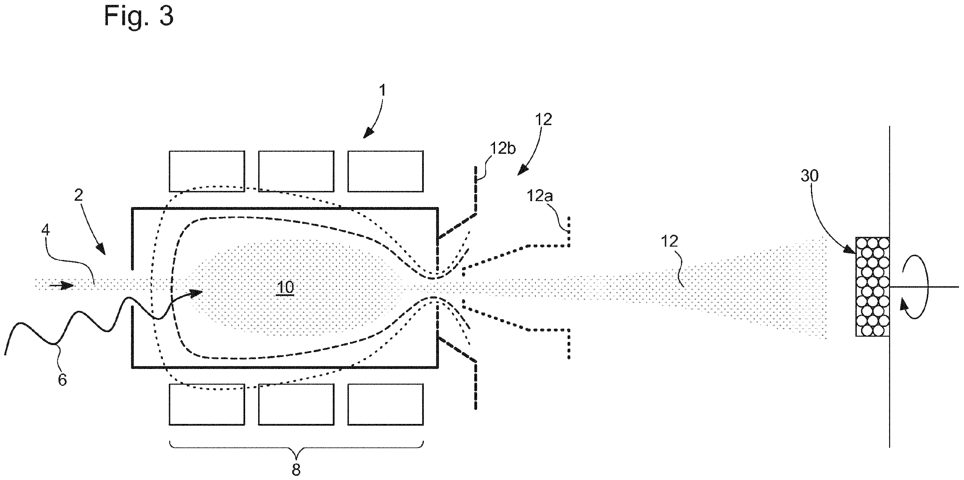

- la figure 3 est une représentation schématique d'une source d'ions multichargés du type à résonance cyclotron électronique ECR utilisée dans le cadre de la présente invention.

### Description détaillée d'un mode de réalisation de l'invention

La présente invention procède de l'idée générale inventive qui consiste à soumettre des particules d'une poudre céramique à un processus de traitement d'implantation d'ions dans la surface de ces particules. En bombardant les particules d'une poudre céramique avec des ions mono- ou multichargés fortement accélérés sous des tensions électriques de l'ordre de 15'000 à 35'000 volts, on se rend compte que ces ions se combinent avec les atomes du matériau céramique pour former un nouveau type de céramique. Jusqu'à une certaine profondeur depuis la surface des particules de poudre céramique, celles-ci se transforment par exemple en carbure ou en nitrure du matériau céramique dans lequel sont réalisées les particules. Avantageusement, les propriétés mécaniques et physiques, notamment la dureté, les propriétés tribologiques et l'usinabilité de ces particules de poudre céramique sont sensiblement améliorées. L'amélioration des propriétés mécaniques et physiques des particules de poudre céramique dotées d'une couche céramique superficielle de type borure, carbure ou nitrure est conservée lorsque ces poudres céramiques sont utilisées pour réaliser des pièces massives par les techniques de frittage des poudres telles que frittage à la pression atmosphérique ou frittage sous pression HIP.

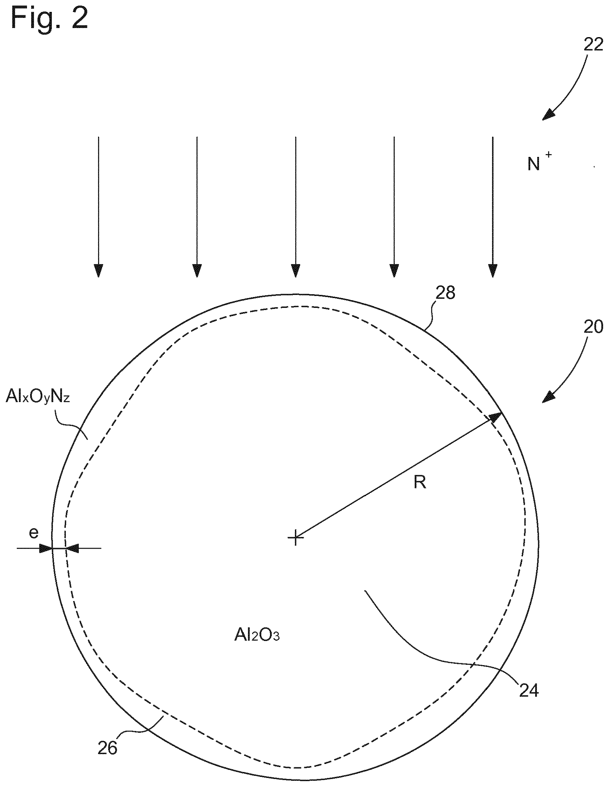

La figure 2 est une vue en coupe d'une particule d'alumine Al₂O₃. Par souci de clarté, on supposera pour les besoins de la démonstration que cette particule d'alumine Al₂O₃ est sensiblement sphérique, étant entendu que, dans la réalité, de telles particules d'alumine Al₂O₃ ont plutôt une forme polyédrique. Désignée dans son ensemble par la référence numérique générale 20, cette particule d'alumine Al₂O₃ présente un rayon R d'environ 1 micromètre. Cette particule d'alumine 20 a été bombardée au moyen d'un faisceau d'ions azote N⁺ désigné par la référence numérique 22. Comme il ressort de la figure 2, la particule d'alumine 20 présente un coeur ou noyau 24 en alumine pure et une couche extérieure ou écorce 26 principalement constituée d'oxynitrure d'alumine AlₓO_{y}N_{z} dont la stoechiométrie varie en fonction de la profondeur depuis la surface de la particule d'alumine 20.

L'épaisseur e de cette couche extérieure 26 est de l'ordre de 7% du rayon R de la particule d'alumine 20, soit environ 70 nanomètres. Cette couche extérieure 26 est en majeure partie constituée d'oxynitrure d'alumine AlₓO_{y}N_{z} qui est un matériau céramique. Selon l'invention, la concentration en AlₓO_{y}N_{z} va en croissant depuis la surface extérieure 28 de la particule d'alumine 20 jusqu'à environ 15% du rayon R de cette particule d'alumine 20, c'est-à-dire environ 140 nanomètres, puis va en décroissant jusqu'à une profondeur d'environ 200 nm sous la surface de la particule d'alumine 20 où elle est sensiblement nulle.

Plus précisément, on a analysé la composition de deux échantillons d'alumine Al₂O₃ appelés respectivement A et B par spectrométrie photoélectronique par rayons X, technique d'analyse également connue sous sa dénomination anglo-saxonne X-ray Photoelectron Spectrometry ou XPS. Ces deux échantillons d'alumine A et B ont été bombardés au moyen d'ions azote N⁺, puis leur concentration en azote depuis la surface vers le coeur de ces échantillons a été examinée par analyse XPS.

Pour ce qui est de l'analyse XPS de l'échantillon d'alumine A, les tests montrent que les atomes d'azote qui pénètrent par bombardement dans la particule d'alumine Al₂O₃ d'origine se lient, pour une part, aux atomes d'aluminium qui entrent dans la composition de l'oxynitrure d'alumine AlₓO_{y}N_{z}, et pour une autre part, ne sont pas liés aux atomes d'aluminium. Plus précisément, les analyses XPS montrent que la concentration en poids atomique de l'azote lié dans les particules d'oxynitrure d'alumine AlₓO_{y}N_{z} présente, depuis la surface vers le coeur de la particule d'alumine Al₂O₃, deux paliers :
- le premier palier de concentration en azote apparaît à une profondeur depuis la surface extérieure des particules d'à-peu-près 70 nm. La concentration moyenne en pourcentage atomique de l'azote lié à l'aluminium de l'oxynitrure d'alumine AlₓO_{y}N_{z} est de l'ordre de 6.3%. Par ailleurs, la stoechiométrie moyenne de la couche d'oxynitrure au niveau de ce palier est proche de AlO_{1.2}N_{0.16}.
- le second palier de concentration en azote apparaît à une profondeur de l'ordre de 140 nm. La concentration moyenne en pourcentage atomique de l'azote lié à l'aluminium est de l'ordre de 3.6%, c'est-à-dire presque moitié moins que la concentration de l'azote lié à l'aluminium observée à 70 nm de profondeur. La stoechiométrie moyenne de la couche d'oxynitrure d'alumine au niveau de ce palier est proche de AlO_{1.3}N_{0.08}.
- Enfin, au-delà d'une profondeur qui excède 140 nm, on observe une chute exponentielle de la concentration en azote lié à l'aluminium qui entre dans la composition de l'oxynitrure d'alumine AlₓO_{y}N_{z}. A une profondeur considérée depuis la surface des particules d'alumine Al₂O₃ qui excède 200 nm, on retrouve un rapport stoechiométrique entre l'oxygène et l'aluminium qui est très proche de celui de l'alumine Al₂O₃.

Pour ce qui est de l'échantillon d'alumine B, l'analyse XPS montre que, dans ce cas également, les atomes d'azote qui pénètrent par bombardement dans la particule d'alumine Al₂O₃ d'origine se lient, pour une part, aux atomes d'aluminium qui entrent dans la composition de l'oxynitrure d'alumine AlₓO_{y}N_{z}, et pour une autre part, ne sont pas liés aux atomes d'aluminium. Plus précisément, les analyses XPS montrent que la concentration en poids atomique de l'azote lié dans les particules d'oxynitrure d'alumine AlₓO_{y}N_{z} présente, depuis la surface vers le coeur de la particule d'alumine Al₂O₃, deux paliers :
- le premier palier de concentration en azote apparaît à une profondeur depuis la surface extérieure des particules d'à-peu-près 25 nm. La concentration moyenne en pourcentage atomique de l'azote lié à l'aluminium est de l'ordre de 3.6%. Par ailleurs, la stoechiométrie moyenne de la couche d'oxynitrure d'alumine au niveau de ce palier est proche de AlO_{1.3}N_{0.09}.
- le second palier de concentration en azote apparaît à une profondeur de l'ordre de 120 nm. La concentration moyenne en pourcentage atomique de l'azote lié à l'aluminium est de l'ordre de 4.7%, c'est-à-dire un peu plus qu'à 25 nm de profondeur. La stoechiométrie moyenne de la couche d'oxynitrure d'alumine au niveau de ce palier est proche de AlO_{1.3}N_{0.11}.
- enfin, au-delà d'une profondeur qui excède 120 nm, on observe une chute exponentielle de la concentration en azote lié à l'aluminium qui entre dans la composition de l'oxynitrure d'alumine AlₓO_{y}N_{z}. A une profondeur considérée depuis la surface des particules d'alumine Al₂O₃ qui excède 200 nm, on retrouve un rapport stoechiométrique entre l'oxygène et l'aluminium qui est très proche de celui de l'alumine Al₂O₃.

Il va de soi que la présente invention n'est pas limitée à la description qui précède et que diverses modifications et variantes simples peuvent être envisagées par l'homme du métier sans sortir du cadre de l'invention telle que défini par les revendications annexées. On comprendra en particulier qu'étant donné que les particules céramiques envisagées ici ont une forme générale polyédrique, on entend par « dimension » de telles particules la dimension extérieure la plus grande d'une telle particule.

### Nomenclature

1. Source d'ions multichargés ECR
2. Etage d'injection
4. Volume d'un gaz à ioniser
6. Onde hyperfréquence
8. Etage de confinement magnétique
10. Plasma
12. Etage d'extraction
12a. Anode
12b. Cathode
14. Faisceau d'ions multichargés
16. Surface
18. Pièce à traiter
20. Particule d'alumine Al₂O₃
R. Rayon
22. Faisceau d'ions azote N⁺
24. Coeur ou noyau
26. Couche extérieure ou écorce
e. Epaisseur
28. Surface extérieure
30. Particules de poudre céramique

## Revendications

1. Procédé de traitement de surface d'un matériau céramique à l'état de poudre, ce procédé comprenant l'étape qui consiste à se munir d'une poudre (30) formée d'une pluralité de particules du matériau céramique à traiter, et à soumettre ces particules de poudre céramique (30) à un processus d'implantation ionique en dirigeant vers une surface extérieure de ces particules un faisceau d'ions (14) monochargés ou multichargés produit par une source d'ions monochargés ou multichargés.

2. Procédé selon la revendication 1, **caractérisé en ce que** l'on agite les particules de la poudre céramique (30) durant toute la durée du processus d'implantation ionique.

3. Procédé selon l'une des revendications 1 ou 2, **caractérisé en ce que** la granulométrie des particules de la poudre céramique (30) utilisée est telle que sensiblement 50% de l'ensemble de ces particules a une dimension inférieure à 2 micromètres.

4. Procédé selon la revendication 3, **caractérisé en ce que** la dimension des particules de poudre céramique (30) utilisée est comprise entre 1.2 micromètres et 63 micromètres.

5. Procédé selon l'une des revendications 1 à 4, **caractérisé en ce que** le matériau céramique est un carbure, un nitrure, un borure ou un oxyde.

6. Procédé selon la revendication 5, **caractérisé en ce que** le matériau céramique de type carbure est bombardé au moyen d'ions azote N pour former un carbonitrure.

7. Procédé selon la revendication 6, **caractérisé en ce que** le matériau céramique est un carbure de titane TiC ou un carbure de silicium SiC, et **en ce que** le produit obtenu après bombardement est du carbonitrure de titane TiCN, respectivement du carbonitrure de silicium SiCN.

8. Procédé selon la revendication 5, **caractérisé en ce que** le matériau céramique de type nitrure est bombardé au moyen d'une dose d'ions comprise entre 1*10¹⁶ cm⁻² et 1*10¹⁷ ions.cm⁻²

9. Procédé selon la revendication 8, **caractérisé en ce que** le matériau céramique est un nitrure de silicium Si₃N₄.

10. Procédé selon la revendication 5, **caractérisé en ce que** le matériau céramique de type oxyde est bombardé au moyen d'ions azote pour former un oxynitrure.

11. Procédé selon la revendication 10, **caractérisé en ce que** le matériau céramique est de la zircone Zr02 ou de l'alumine Al₂O₃, et **en ce que** le produit obtenu après bombardement est du nitrure de zircone ZrₓO_{y}N_{z}, ou bien du nitrure de zirconium ZrN, ou bien du nitrure d'alumine AlₓO_{y}N_{z}.

12. Procédé selon la revendication 5, **caractérisé en ce que** le matériau céramique de type oxyde est bombardé au moyen d'ions carbone pour former un carbonitrure.

13. Procédé selon la revendication 12, **caractérisé en ce que** le matériau céramique est de la zircone Zr02 ou de l'alumine Al₂O₃, et **en ce que** le produit obtenu après bombardement est du carbure de zircone Zr02C, respectivement du carbure de zirconium ZrC.

14. Procédé selon la revendication 5, **caractérisé en ce que** le matériau céramique de type oxyde est bombardé au moyen d'ions bore pour former un oxyborure, notamment du borure de zircone Zr02B.

15. Procédé selon la revendication 14, **caractérisé en ce que**, si l'on prolonge le bombardement ionique suffisamment longtemps, on obtient du borure de zircone ZrB₂.

16. Procédé selon l'une des revendications 1 à 15, **caractérisé en ce que** le processus d'implantation ionique est du type à résonance cyclotron électronique ECR.

17. Procédé selon la revendication 16, **caractérisé en ce que** les ions monochargés ou multichargés sont accélérés sous une tension comprise entre 15'000 et 35'000 volts.

18. Procédé selon l'une des revendications 16 et 17, **caractérisé en ce que** la dose d'ions implantée est comprise entre 1.10¹⁴ et 5.10¹⁷ ions.cm⁻², préférentiellement entre 1.10¹⁶ et 1.10¹⁷ ions.cm"⁻²

19. Procédé selon l'une des revendications 16 et 17, **caractérisé en ce que** les ions pénètrent dans les particules formant la poudre de matériau céramique jusqu'à une profondeur correspondant à environ 20% de la dimension de ces particules.

20. Matériau à l'état de poudre formé d'une pluralité de particules ayant une couche extérieure (26) céramique et un coeur (24) céramique, ces particules ayant une forme générale polyédrique, la couche extérieure (26) correspondant à un borure, un carbure ou un nitrure du matériau céramique dans lequel est réalisé le coeur (24) des particules de la poudre céramique.

21. Matériau selon la revendication 20, **caractérisé en ce qu'**environ 50% des particules ont une dimension inférieure à 2 micromètres.

22. Matériau selon la revendication 21, **caractérisé en ce que** la dimension des particules de poudre céramique (30) utilisée est comprise entre 1.2 micromètres et 63 micromètres.

23. Matériau selon l'une des revendications 19 à 21, **caractérisé en ce que** le matériau céramique dans lequel sont réalisées les particules de la poudre céramique (30) est un borure, un carbure, oxyde ou un nitrure.
